# FASCICULE DE BREVET EUROPEEN

(11) **EP 1 226 611 B1**
(45) Date de publication et mention de la délivrance du brevet: **20.12.2006**
(21) Numéro de dépôt: 00974604.1
(22) Date de dépôt: 30.10.2000
(51) Int. Cl.: H01L 31/0203, H01L 25/16

(54) **BOITIER SEMI-CONDUCTEUR OPTIQUE ET PROCEDE DE FABRICATION D'UN TEL BOITIER**
GEHÄUSE FÜR OPTISCHE HALBLEITERELEMENTE UND HERSTELLUNGSVERFAHREN SOLCHER GEHÄUSE
OPTICAL SEMICONDUCTOR HOUSING AND METHOD FOR MAKING SAME

(30) Priorité: 04.11.1999 FR 9913778
(43) Date de publication de la demande: 31.07.2002
(73) Titulaire: STMicroelectronics S.A., 92120 Montrouge (FR)
(72) Inventeur: EXPOSITO, Juan, F-38330 Saint Nazaire les Eymes (FR); BRECHIGNAC, Rémi, F-38000 Grenoble (FR)
(74) Mandataire: Casalonga, Axel
(86) Numéro de dépôt international: PCT/FR2000/003023
(87) Numéro de publication internationale: WO 2001/033638

(56) Documents cités:
- EP-A- 0 790 652
- EP-A- 0 807 976
- JP-A- 7 326 779
- US-A- 5 523 608
- PATENT ABSTRACTS OF JAPAN vol. 013, no. 232 (E-765), 29 mai 1989 (1989-05-29) & JP 01 039048 A (HITACHI LTD;OTHERS: 01), 9 février 1989 (1989-02-09)
- PATENT ABSTRACTS OF JAPAN vol. 1998, no. 10, 31 août 1998 (1998-08-31) & JP 10 144965 A (HAMAMATSU PHOTONICS KK), 29 mai 1998 (1998-05-29)

## Description

La présente invention concerne un procédé de fabrication d'un boîtier semi-conducteur optique et un tel boîtier semi-conducteur optique.

On connaît des boîtiers semi-conducteurs optiques comprenant plusieurs composants semi-conducteurs de façon à pouvoir délivrer des données d'images à partir des données d'un composant semi-conducteur à capteur optique, dans lesquels les composants sont fixés de part et d'autre d'une plaque. De tels boîtiers sont décrits dans les documents US-A-5 523608, EP-A-0 807 976, JP-A-10144965 et JP-A-7326779.

Le but de la présente invention est de proposer une structure de boîtier semi-conducteur optique comprenant plusieurs composants semi-conducteurs et un procédé de fabrication d'un tel boîtier de telle sorte que ce boîtier présente un encombrement réduit.

Selon un objet de l'invention, le procédé de fabrication d'un boîtier semi-conducteur optique consiste, successivement : à réaliser un passage au travers d'une plaque support de connexion électrique ; à fixer la face avant d'un premier composant semi-conducteur tel qu'un microprocesseur autour dudit passage de ladite plaque support et à relier électriquement ce premier composant à ladite plaque support ; à mouler sur la face arrière de ladite plaque support un bloc d'encapsulation dudit premier composant ; à fixer directement sur la face avant dudit premier composant, au travers dudit passage de ladite plaque support, un second composant semi-conducteur dont une face avant comprend un capteur optique et à relier électriquement ce second composant à ladite plaque support ; et à encapsuler ledit second composant sur la face avant de ladite plaque support.

Selon l'invention, le procédé peut avantageusement consister, successivement : à mouler sur la face arrière de ladite plaque support un bloc d'encapsulation dudit premier composant et sur la face avant de ladite plaque support la paroi en saillie d'une cavité, à fixer au fond de ladite cavité le second composant semi-conducteur sur le premeir composant et à relier électriquement ce second composant à ladite plaque support, et à fermer ladite cavité par un couvercle au moins en partie transparent.

Selon l'invention, le procédé peut avantageusement consister à encapsuler ledit second composant sur la face avant de ladite plaque support grâce à un couvercle en forme de cuvette.

Selon l'invention, le procédé peut avantageusement consister à relier électriquement ledit premier composant à ladite plaque support par des fils électriques.

Selon l'invention, le procédé peut avantageusement consister à relier électriquement ledit second composant à ladite plaque support par des fils électriques.

Selon l'invention, le procédé peut avantageusement consister à fixer et relier électriquement ledit premier composant à ladite plaque support par des billes de connexion électrique s'interposant entre eux.

Selon l'invention, le procédé peut avantageusement consister, lors, desdites opérations d'encapsulage desdits composants, à laisser découverte une partie d'au moins l'une des faces de ladite plaque support, cette partie découverte comprenant des zones et/ou plots de connexions électriques.

Selon l'invention, le procédé peut avantageusement consister à fixer et relier électriquement un organe de connexion électrique extérieure sur une partie découverte de ladite plaque support.

Selon l'invention, le procédé peut avantageusement consister à fixer et relier électriquement des billes de connexion électrique extérieure sur une partie découverte de ladite plaque support.

Selon l'invention, le procédé peut avantageusement consister à fixer et relier électriquement au moins un composant passif sur ladite plaque support.

Selon un objet de l'invention, le boîtier semi-conducteur optique comprend : une plaque support de connexion électrique qui comprend des lignes internes et/ou externes constituant un réseau de connexions électriques présentant des zones et/ou plots de connexions électriques et qui présente un passage traversant ; un premier composant semi-conducteur tel qu'un microprocesseur dont une face avant est fixée sur une face arrière de ladite plaque support autour dudit passage ; des premiers moyens de connexion électrique dudit premier composant à ladite plaque support ; un second composant semi-conducteur dont une face avant comprend un capteur optique et dont une face arrière est fixée directement sur la face avant dudit premier composant, au travers dudit passage de ladite plaque support ; des seconds moyens de connexion électrique dudit second composant à ladite plaque support ; un bloc d'encapsulation dudit premier composant sur la face arrière de ladite plaque support ; une cavité d'encapsulation au fond de laquelle est disposé ledit second composant et dont la paroi avant est au moins en partie transparente ; et des moyens de connexion extérieure disposés sur une partie découverte de ladite plaque support.

Selon l'invention, la paroi de ladite cavité peut avantageusement comprendre une paroi d'encapsulation en saillie sur la face avant de ladite plaque support et un couvercle fixé sur l'extrémité avant de ladit paroi en saillie et au moins en partie transparent.

Selon l'invention, la paroi de ladite cavité peut avantageusement comprendre un couvercle en forme cuvette fixé sur la face avant de ladite plaque support.

Selon l'invention, le boîtier peut avantageusement comprendre au moins un composant passif disposé sur ladite plaque support.

Selon l'invention, lesdits premiers moyens de connexion électrique peuvent avantageusement comprendre des fils électriques.

Selon l'invention, lesdits premiers moyens de connexion électrique peuvent avantageusement comprendre des billes métalliques.

Selon l'invention, lesdits seconds moyens de connexion électrique peuvent avantageusement comprendre des fils électriques.

Selon l'invention, ladite plaque support comprend une partie évidée au fond de laquelle est fixé ledit premier composant.

Selon l'invention, le boîtier peut avantageusement comprendre au moins un composant passif fixé sur ladite plaque support et connecté électriquement à cette dernière.

La présente invention sera mieux comprise à l'étude de boîtiers semi-conducteurs optiques et de leurs procédés de fabrication, décrits à titre d'exemples non limitatifs et illustrés par le dessin sur lequel :
- la figure 1 représente une première étape de fabrication d'un premier boîtier selon la présente invention, en vue de côté ;
- la figure 2 représente une seconde étape de fabrication dudit boîtier ;
- la figure 3 représente une troisième étape de fabrication dudit premier boîtier selon une première variante d'exécution de ce dernier ;
- la figure 4 représente une quatrième étape de fabrication dudit premier boîtier ;
- la figure 5 représente une quatrième et dernière étape de fabrication dudit premier boîtier ;
- la figure 6 représente une vue de dessus dudit premier boîtier selon la figure 5 ;
- la figure 7 représente une première étape de fabrication d'un second boîtier selon la présente invention, en vue de côté ;
- la figure 8 représente une seconde étape de fabrication dudit second boîtier ;
- la figure 9 représente une troisième étape de fabrication dudit second boîtier selon une première variante d'exécution de ce dernier ;
- la figure 10 représente une quatrième étape de fabrication dudit second boîtier ;
- la figure 11 représente une quatrième et dernière étape de fabrication dudit second boîtier ;
- la figure 12 représente une vue de dessus dudit second boîtier selon la figure 11 ;
- et la figure 13 représente une variante d'exécution de boîtiers précités.

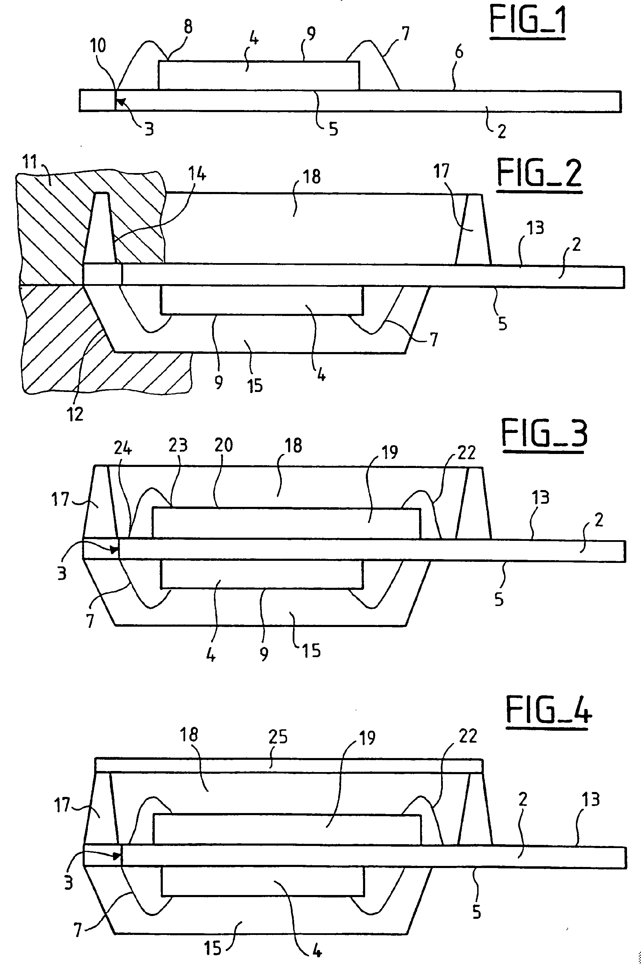

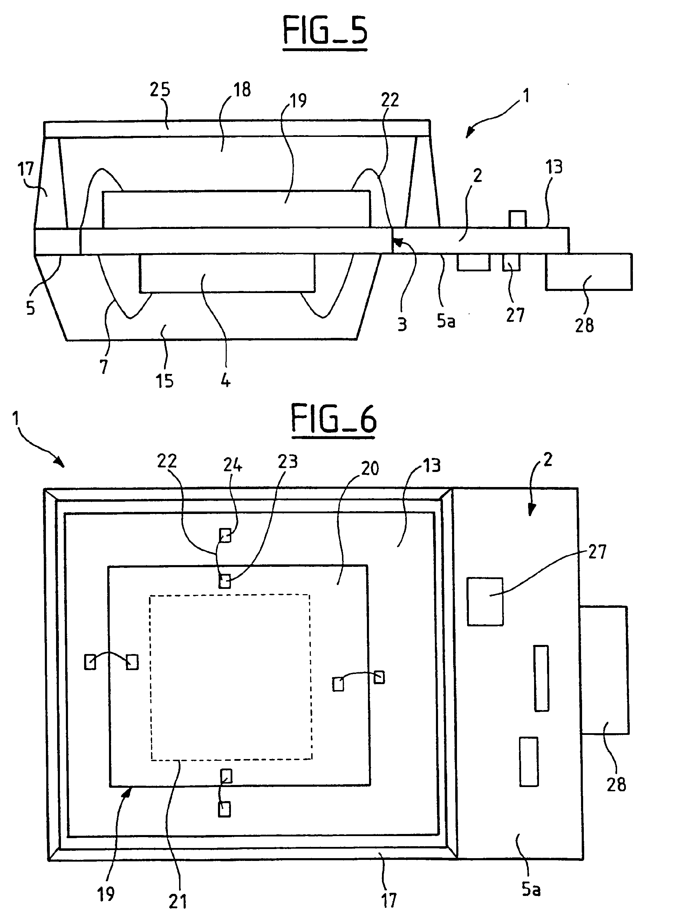

En se reportant aux figures 1 à 6, on va tout d'abord décrire les différentes étapes de fabrication d'un boîtier semi-conducteur optique repéré d'une manière générale par la référence 1 et représenté terminé sur les figures 5 et 6.

En se reportant à la figure 1, on voit qu'on dispose, de façon préfabriquée, d'un substrat 2 constitué par une plaque support qui présente des lignes internes et/ou externes constituant un réseau 3 de connexions électriques et d'un premier composant semi-conducteur 4 tel qu'un microprocesseur ou coprocesseur.

Dans une première étape de fabrication, on fixe une face avant 5 du premier composant 4 sur une face arrière 6 de la plaque support 1, à plat sur cette dernière et par l'intermédiaire d'une couche de colle ou tout autre moyen. Puis, on fixe l'une des extrémités des fils électriques 7 sur des plots métalliques 8 formés en surface sur la face arrière 9 du composant 4 et on fixe l'autre extrémité des fils de connexion électrique 7 à des plots métalliques 10 du réseau 3, formés en surface sur la face arrière 6 de la plaque support 2 et à distance de la périphérie du composant 4.

Dans une seconde étape de fabrication représentée sur la figure 2, on installe la plaque support 2 et le composant 4 de la figure 1 tels que montés dans un moule 11 qui présente du côté de la face arrière 5 de la plaque 2, une cavité 12 dans laquelle s'étend le composant 4 et les fils de connexion électrique 7 et, du côté de la face avant 13 de la plaque support 2, une cavité annulaire 14.

Ensuite, on injecte une matière d'enrobage dans les cavités 12 et 14 du moule 11 de manière d'une part à encapsuler le composant 4 et les fils de connexion électrique 7 dans un bloc 15 et d'autre part à créer une paroi annulaire 17 déterminant une cavité 18 du côté de la face avant 13 de la plaque support 2. Puis, on procède au démoulage.

Dans une troisième étape de fabrication représentée sur la figure 3, on fixe par l'intermédiaire d'une couche de colle ou tout autre moyen, la face arrière d'un second composant semi-conducteur 19 sur la face avant 13 de la plaque support 2 et au centre du fond de la cavité 18, la face avant 20 du composant 19 présentant dans sa partie centrale un capteur optique 21.

Ensuite, on relie électriquement le composant optique 19 au réseau de connexion électrique 3 de la plaque support 2 en fixant l'une des extrémités des fils de connexion électrique 22 à des plots métalliques 23 formés en surface sur la face avant 20 du composant optique 19 autour du capteur optique 21 et en fixant l'autre extrémité des fils de connexion électrique 22 à des plots métalliques 24 du réseau 3, formés en surface sur la face avant 13 de la plaque support 1 et entre la périphérie du composant optique 19 et la paroi en saillie 17.

Dans une quatrième étape de fabrication représentée sur la figure 4, on ferme la cavité 18 grâce à un couvercle transparent 25 dont on fixe la périphérie sur l'extrémité 26 de la paroi moulée en saillie 17, le composant optique 19 et les fils de connexion électrique 22 se trouvant ainsi encapsulés dans la cavité 18 en avant de la face avant 13 de la plaque support 2.

Dans une cinquième étape de fabrication représentée sur la figure 5, on fixe des composants électroniques passifs 27 tels que des résistances et/ou des condensateurs, sur la partie découverte 5a de la face arrière 5 de la plaque support 2, située latéralement au bloc d'enrobage 15, ces composants électroniques 27 étant en même temps connectés électriquement au réseau de connexion électrique 3 de la plaque support 2.

De plus, on fixe et on relie électriquement au bord de la partie découverte 5a de la plaque support 2 un organe de connexion électrique extérieure 28. Cet organe 28 pourrait être remplacé par un dépôt sur la plaque support 2 d'une multiplicité de billes métalliques espacées.

On obtient ainsi, comme le montrent les figures 5 et 6, un boîtier semi-conducteur optique 1 complet, équipé d'un composant semi-conducteur optique 19 et de différents composants électroniques de traitement 4 et 27, reliés électriquement de façon adaptée par l'intermédiaire du réseau de connexion électrique 3 de la plaque support 1 et susceptibles d'être connectés à un circuit extérieur grâce au connecteur électrique 28 ou à des billes métalliques ou des zones métalliques en surface équivalentes.

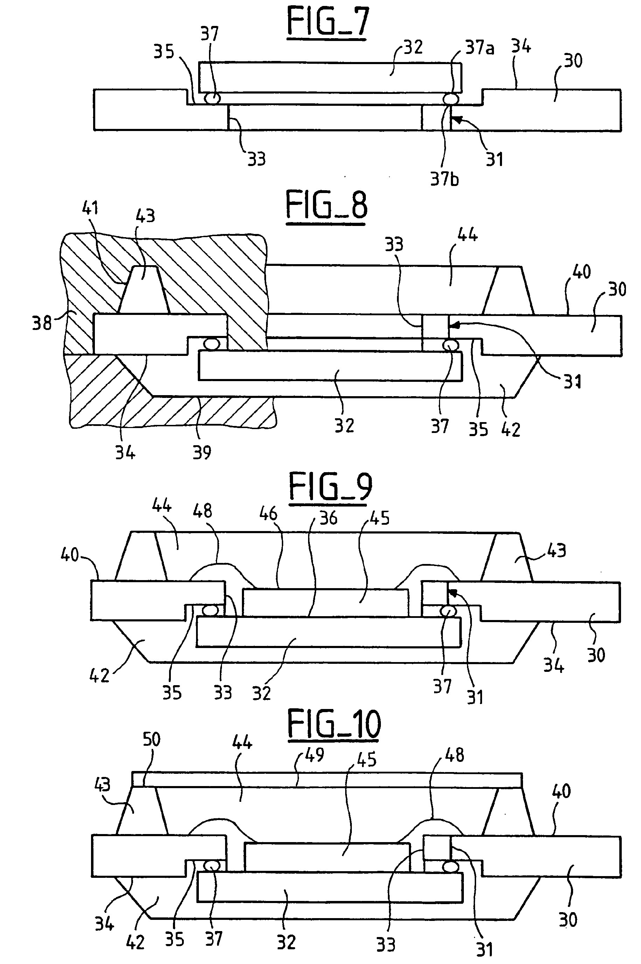

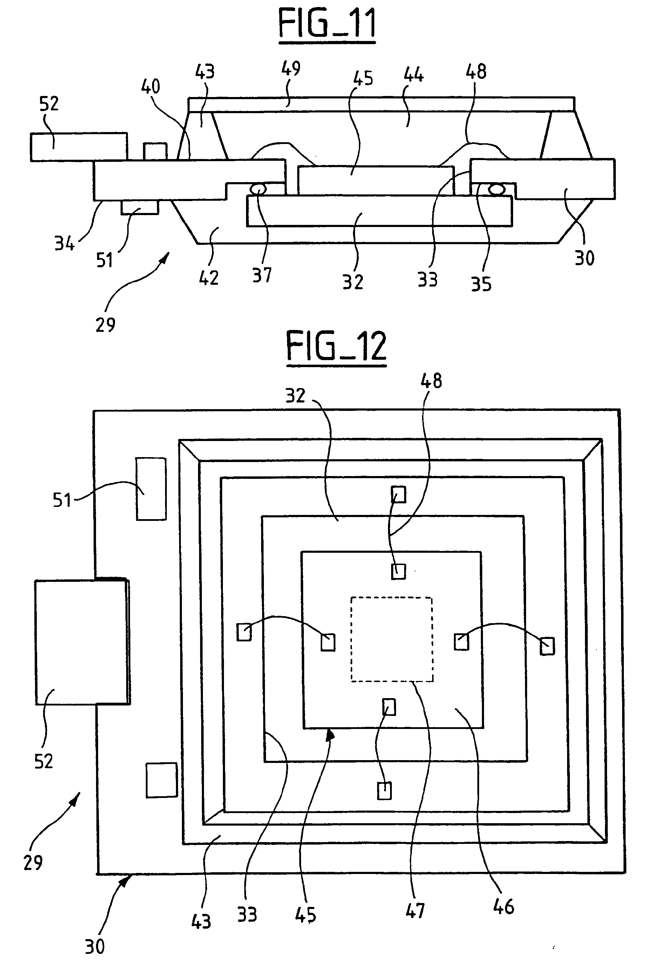

En référence aux figures 7 à 12, on va maintenant décrire les différentes étapes de fabrication d'un autre boîtier semi-conducteur optique repéré d'une manière générale par la référence 29 et représenté terminé sur les figures 11 et 12.

En se reportant à la figure 7, on voit qu'on dispose pour celà, de façon préfabriquée, d'un substrat 30 constitué par une plaque support qui présente des lignes internes et/ou externes constituant un réseau 31 de connexions électriques et d'un premier composant semi-conducteur 32 tel qu'un micro-processeur ou coprocesseur, la plaque support 30 présentant un passage traversant 33 autour duquel la face arrière 34 de la plaque support 30 présente un évidement ou lamage annulaire 35.

Dans une première étape de fabrication, on fixe et on connecte électriquement la face avant 36 du composant 32 au fond de l'évidement annulaire 35 par l'intermédiaire d'une multiplicité de billes métalliques 37 réparties qui sont interposées entre des plots métalliques de connexion 37a et 37b réalisés en surface d'une part sur la face avant 36 du composant 32 et d'autre part au fond de l'évidement 35. Dans cette position assemblée, le composant 32 pénétre légèrement dans l'évidement 35.

Dans une seconde étape de fabrication représentée sur la figure 8, on installe la plaque support 30 et le composant 32 de la figure 1 tels que montés dans un moule 38 qui présente du côté de la face arrière 34 de la plaque support 30, une cavité 39 dans laquelle s'étend le composant 32 et, du côté de la face avant 40 de la plaque support 30, une cavité annulaire 41. Le moule 38 présente une partie 38a qui s'engage dans le passage traversant 33 de la plaque support 30 et qui vient en contact avec la face avant 36 du composant 32 de façon à obstruer le passage entre la plaque support 30 et le composant 32 dans lequel sont disposées les billes métalliques 37.

Ensuite, on injecte une matière d'enrobage dans les cavités 39 et 41 du moule 38 de manière d'une part à encapsuler le composant 32 et les billes de connexion électrique 37 dans un bloc 42 et d'autre part à créer une paroi annulaire en saillie 43. Cette paroi en saillie 43 détermine une cavité 44 du côté de la face avant 40 de la plaque support 30 qui s'étend en profondeur jusqu'à la face avant 36 du composant 32. Puis, on procède au démoulage.

Dans une troisième étape de fabrication représentée sur la figure 9, on fixe par l'intermédiaire d'une couche de colle, ou tout autre moyen, la face arrière d'un second composant semi-conducteur 19 sur la face avant 36 du composant 32 et au centre du fond de la cavité 4, la face avant 46 du composant 19 présentant comme dans l'exemple précédent un capteur optique 47 dans sa partie centrale.

Ensuite, comme dans l'exemple précédent, on relie électriquement la face avant 46 du composant optique 45 au réseau de connexion électrique 31 de la plaque support 30 par des fils de connexion électrique 48.

Dans une quatrième étape de fabrication représentée sur la figure 10, comme dans l'exemple précédent, on ferme la cavité 4 grâce à un couvercle transparent 49 dont on fixe la périphérie sur l'extrémité 50 de la paroi moulée en saillie 43 de façon à encapsuler le composant optique 45 et les fils de connexion électrique 48 dans la cavité 44.

Dans une cinquième étape de fabrication représentée sur la figure 11, comme dans l'exemple précédent, on fixe sur la partie découverte de la plaque support 30 et on connecte au réseau 31 des composants électroniques passifs 51 et un organe de connexion électrique extérieure 52 ou une multiplicité de billes métalliques espacées de connexion électrique extérieure.

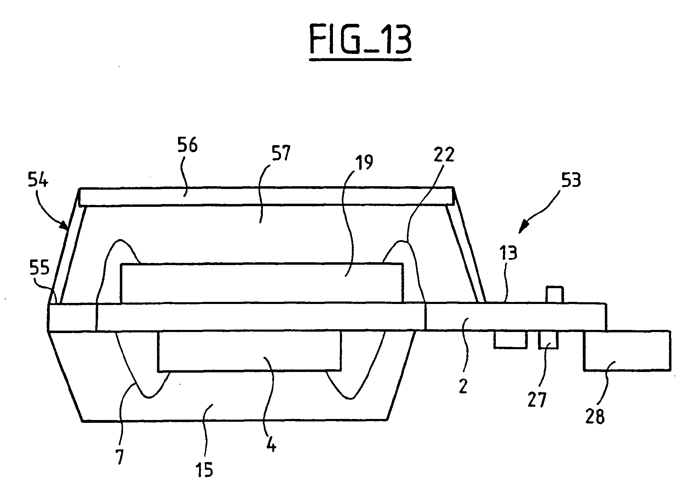

En se reportant à la figure 13, on voit qu'on a représenté un boîtier 53 qui se différencie des boîtiers 1 décrits en référence aux figures 1 à 6 par le fait qu'on moule uniquement le bloc d'encapsulage 15 et que la partie en saillie 17 et le couvercle 25 sont remplacés par un couvercle 54 en forme de cuvette dont le bord périphérique est collé sur la face avant 13 de la plaque support et dont le fond 56 s'étend à distance du composant 19, de façon à délimiter une cavité d'encapsulage 57, ce fond 56 étant transparent. La même disposition pourrait être appliquée au boîtier 29 décrit en référence aux figures 7 à 12.

Selon d'autres réalisations, les composants électroniques passifs auraient pu être intégrés aux blocs moulés précités ou fixés au fond desdits cavités.

## Revendications

1. Procédé de fabrication d'un boîtier semi-conducteur optique, **caractérisé par le fait qu'**il consiste, successivement :
à réaliser un passage (33) au travers d'une plaque support de connexion électrique (30) ;
à fixer la face avant d'un premier composant semi-conducteur (32) tel qu'un microprocesseur autour dudit passage de ladite plaque support (30) et à relier électriquement ce premier composant à ladite plaque support ;
à mouler sur la face arrière de ladite plaque support un bloc d'encapsulation (42) dudit premier composant (32) ;
à fixer directement sur la face avant dudit premier composant (32), au travers dudit passage (33) de ladite plaque support (30), un second composant (45) dont une face avant comprend un capteur optique (21) et à relier électriquement ce second composant à ladite plaque support ;
et à encapsuler ledit second composant (19) sur la face avant de ladite plaque support (30).

2. Procédé selon la revendication 1, **caractérisé par le fait qu'**il consiste, successivement :
à mouler sur la face arrière de ladite plaque support un bloc d'encapsulation (42) dudit premier composant et sur la face avant de ladite plaque support la paroi en saillie (43) d'une cavité (44),
à fixer au fond de ladite cavité le second composant semi-conducteur (45) sur le premeir composant (32) et à relier électriquement ce second composant à ladite plaque support (30),
et à fermer ladite cavité par un couvercle (49) au moins en partie transparent.

3. Procédé selon la revendication 1, **caractérisé par le fait qu'**il consiste à encapsuler ledit second composant (45) sur la face avant de ladite plaque support (30) grâce à un couvercle (54) en forme de cuvette.

4. Procédé selon l'une quelconque des revendications précédentes, **caractérisé par le fait qu'**il consiste à relier électriquement ledit premier composant à ladite plaque support par des fils électriques (7).

5. Procédé selon l'une quelconque des revendications précédentes, **caractérisé par le fait qu'**il consiste à relier électriquement ledit second composant à ladite plaque support par des fils électriques (22).

6. Procédé selon l'une quelconque des revendications précédentes, **caractérisé par le fait qu'**il consiste à fixer et relier électriquement ledit premier composant (32) à ladite plaque support (30) par des billes de connexion électrique (37) s'interposant entre eux.

7. Procédé selon l'une quelconque des revendications précédentes, **caractérisé par le fait qu'**il consiste, lors desdites opérations d'encapsulage desdits composants, à laisser découverte une partie (5a) d'au moins l'une des faces de ladite plaque support, cette partie découverte comprenant des zones et/ou plots de connexions électriques.

8. Procédé selon l'une quelconque des revendications précédentes, **caractérisé par le fait qu'**il consiste à fixer et relier électriquement un organe de connexion électrique extérieure (28) sur une partie découverte de ladite plaque support.

9. Procédé selon l'une quelconque des revendications précédentes, **caractérisé par le fait qu'**il consiste à fixer et relier électriquement des billes de connexion électrique extérieure sur une partie découverte de ladite plaque support.

10. Procédé selon l'une quelconque des revendications précédentes, **caractérisé par le fait qu'**il consiste à fixer et relier électriquement au moins un composant passif (27) sur ladite plaque support.

11. Boîtier semi-conducteur optique, **caractérisé par le fait qu'**il comprend :
une plaque support de connexion électrique (30) qui comprend des lignes internes et/ou externes constituant un réseau (31) de connexions électriques présentant des zones et/ou plots de connexions électriques et qui présente un passage traversant (33) ;
un premier composant semi-conducteur (32) tel qu'un microprocesseur dont une face avant est fixée sur une face arrière de ladite plaque support autour dudit passage (33) ;
des premiers moyens de connexion électrique dudit premier composant à ladite plaque support ;
un second composant semi-conducteur (32) dont une face avant comprend un capteur optique (21) et dont une face arrière est fixée directement sur la face avant dudit premier composant (32), au travers dudit passage (33) de ladite plaque support (30) ;
des seconds moyens de connexion électrique dudit second composant à ladite plaque support ;
un bloc d'encapsulage (42) dudit premier composant sur la face arrière de ladite plaque support ;
une cavité d'encapsulage (44) au fond de laquelle est disposé ledit second composant et dont la paroi avant (49) est au moins en partie transparente ;
et des moyens de connexion extérieure disposés sur une partie découverte de ladite plaque support.

12. Boîtier selon la revendication 11, **caractérisé par le fait que** la paroi de ladite cavité (18) comprend une paroi d'encapsulation (17) en saillie sur la face avant de ladite plaque support et un couvercle (25) fixé sur l'extrémité avant de ladit paroi en saillie et au moins en partie transparent.

13. Boîtier selon la revendication 11, **caractérisé par le fait que** la paroi de ladite cavité (18) comprend un couvercle en forme cuvette fixé sur la face avant de ladite plaque support.

14. Boîtier selon l'une quelconque des revendications 11 à 13, **caractérisé par le fait qu'**il comprend au moins un composant passif (27) disposé sur ladite plaque support (2).

15. Boîtier selon l'une quelconque des revendications 11 à 14, **caractérisé par le fait que** lesdits premiers moyens de connexion électrique comprennent des fils électriques (7).

16. Boîtier selon l'une quelconque des revendications 11 à 15, **caractérisé par le fait que** lesdits premiers moyens de connexion électrique comprennent des billes métalliques (37).

17. Boîtier selon l'une quelconque des revendications 11 à 16, **caractérisé par le fait que** lesdits seconds moyens de connexion électrique comprennent des fils électriques (22).

18. Boîtier selon l'une quelconque des revendications 11 à 17, **caractérisé par le fait que** ladite plaque support comprend une partie évidée (35) au fond de laquelle est fixé ledit premier composant (32).

19. Boîtier selon l'une quelconque des revendications 11 à 18, **caractérisé par le fait qu'**il comprend au moins un composant passif (27) fixé sur ladite plaque support et connecté électriquement à cette dernière.

## Claims

1. Process for fabricating an optical semiconductor package, **characterized in that** it consists, in turn:
in producing a passage (33) through an electrical connection support plate (30);
in fixing the front face of a first semiconductor component (32) such as a microprocessor around said passage in said support plate and electrically linking this first component to said support plate;
in moulding on the rear face of said support plate a block (42) for encapsulating said first component (32);
in directly fixing on the front face of said first component (32), through said passage (33) in said support plate (30), a second semiconductor component (45), a front face of which comprises an optical sensor (21) and in electrically linking this second component to said support plate;
and in encapsulating said second component (19) on the front face of said support plate (30).

2. Process according to Claim 1, **characterized in that** it consists, in turn:
in moulding on the rear face of said support plate a block (42) for encapsulating said first component and
on the front face of said support plate the projecting wall (43) of a cavity (44),
in fixing at the bottom of said cavity the second semiconductor component (45) on the first component (32) and in electrically linking this second component to said support plate (30),
and in closing said cavity with a lid (49) that is at least partly transparent.

3. Process according to Claim 1, **characterized in that** it consists in encapsulating said second component (45) on the front face of said support plate (30) using a dish-shaped lid (54).

4. Process according to any one of the preceding claims, **characterized in that** it consists in electrically linking said first component to said support plate by electrical wires (7).

5. Process according to any one of the preceding claims, **characterized in that** it consists in electrically linking said second component to said support plate by electrical wires (22).

6. Process according to any one of the preceding claims, **characterized in that** it consists in fixing and electrically linking said first component (32) to said support plate (30) by electrical connection balls (37) placed between them.

7. Process according to any one of the preceding claims, **characterized in that** it consists, in said encapsulation operations of said components, in leaving exposed a part (5a) of at least one of the faces of said support plate, this exposed part comprising electrical connection areas and/or pads.

8. Process according to any one of the preceding claims, **characterized in that** it consists in fixing and electrically linking an external electrical connection device (28) to an exposed part of said support plate.

9. Process according to any one of the preceding claims, **characterized in that** it consists in fixing and electrically linking external electrical connection balls to an exposed part of said support plate.

10. Process according to any one of the preceding claims, **characterized in that** it consists in fixing and electrically linking at least one passive component (27) on said support plate.

11. Optical semiconductor package, **characterized in that** it comprises:
an electrical connection support plate (30) which comprises internal and/or external lines forming a network (31) of electrical connections having electrical connection areas and/or pads and which has a through-passage (33);
a first semiconductor component (32) such as a microprocessor, a front face of which is fixed on a rear face of said support plate around said passage (33);
first means of electrically connecting said first component to said support plate;
a second semiconductor component (32), a front face of which comprises an optical sensor (21) and a rear face of which is directly fixed onto the front face of said first component (32), through said passage (33) in said support plate (30);
second means of electrically connecting said second component to said support plate;
a block (42) for encapsulating said first component on the rear face of said support plate;
an encapsulation cavity (44), at the bottom of which is positioned said second component and the front wall (49) of which is at least partly transparent;
and external connection means located on an exposed part of said support plate.

12. Package according to Claim 11, **characterized in that** the wall of said cavity (18) comprises a projecting encapsulation wall (17) on the front face of said support plate and a lid (25) fixed on the front end of said projecting wall and at least partly transparent.

13. Package according to Claim 11, **characterized in that** the wall of said cavity (18) comprises a dish-shaped lid fixed on the front face of said support plate.

14. Package according to any one of Claims 11 to 13, **characterized in that** it comprises at least one passive component (27) positioned on said support plate (2).

15. Package according to any one of Claims 11 to 14, **characterized in that** said first electrical connection means comprise electrical wires (7).

16. Package according to any one of Claims 11 to 15, **characterized in that** said first electrical connection means comprise metal balls (37).

17. Package according to any one of Claims 11 to 16, **characterized in that** said second electrical connection means comprise electrical wires (22).

18. Package according to any one of Claims 11 to 17, **characterized in that** said support plate comprises a hollow part (35) at the bottom of which is fixed said first component (32).

19. Package according to any one of Claims 11 to 18, **characterized in that** it comprises at least one passive component (27) fixed on said support plate and electrically connected to the latter.

## Patentansprüche

1. Verfahren zur Herstellung eines Gehäuses für optische Halbleiterelemente, **dadurch gekennzeichnet, daß** es nacheinander aufweist:
Herstellen eines Durchgangs (33) durch eine Trägerplatte (30) mit elektrischen Anschlüssen;
Befestigen der vorderen Fläche eines ersten Halbleiterelements (32), beispielsweise eines Mikroprozessors, um den Durchgang der Trägerplatte (30) herum und elektrisches Anschließen dieses ersten Elements an der Trägerplatte;
Gießen eines Einkapselungsblocks (42) des ersten Elements (32) an der hinteren Fläche der Trägerplatte;
Befestigen eines zweiten Halbleiterelements (45), dessen vordere Fläche einen optischen Sensor (21) aufweist, durch den Durchgang (33) der Trägerplatte (30) hindurch direkt an der vorderen Fläche des ersten Elements (32) und elektrisches Anschließen dieses zweiten Elements an der Trägerplatte; und
Einkapseln des zweiten Elements (19) an der vorderen Fläche der Trägerplatte (30).

2. Verfahren nach Anspruch 1, **dadurch gekennzeichnet, daß** es nacheinander aufweist:
Gießen eines Einkapselungsblocks (42) des ersten Elements an der hinteren Fläche der Trägerplatte und Gießen einer vorspringenden Wand (43) eines Hohlraums (44) an der vorderen Fläche der Trägerplatte;
Befestigen des zweiten Halbleiterelements (45) an dem ersten Element (32) im unteren Teil des Hohlraums und elektrisches Anschließen dieses zweiten Elements an der Trägerplatte (30); und
Schließen des Hohlraums mit einem zumindest teilweise transparenten Deckel (49).

3. Verfahren nach Anspruch 1, **dadurch gekennzeichnet, daß** es aufweist, das zweite Element (45) an der vorderen Fläche der Trägerplatte (30) mit Hilfe eines Deckels (54) in Form einer Küvette einzukapseln.

4. Verfahren nach einem der vorstehenden Ansprüche, **dadurch gekennzeichnet, daß** es aufweist, das erste Element über elektrische Drähte (7) elektrisch an der Trägerplatte anzuschließen.

5. Verfahren nach einem der vorstehenden Ansprüche, **dadurch gekennzeichnet, daß** es aufweist, das zweite Element über elektrische Drähte (22) elektrisch an der Trägerplatte anzuschließen.

6. Verfahren nach einem der vorstehenden Ansprüche, **dadurch gekennzeichnet, daß** es aufweist, das erste Element (32) über zwischenliegende elektrische Anschlußkügelchen (37) an der Trägerplatte zu befestigen und elektrisch anzuschließen.

7. Verfahren nach einem der vorstehenden Ansprüche, **dadurch gekennzeichnet, daß** es aufweist, daß beim Einkapseln der Elemente ein Teil (5a) mindestens einer der Flächen der Trägerplatte unbedeckt bleibt, wobei dieser unbedeckte Teil elektrische Anschlußzonen und/oder -kontakte aufweist.

8. Verfahren nach einem der vorstehenden Ansprüche, **dadurch gekennzeichnet, daß** es aufweist, ein externes elektrisches Anschlußbauteil (28) an einem unbedeckten Teil der Trägerplatte zu befestigen und elektrisch anzuschließen.

9. Verfahren nach einem der vorstehenden Ansprüche, **dadurch gekennzeichnet, daß** es aufweist, externe elektrische Anschlußkügelchen an einem unbedeckten Teil der Trägerplatte zu befestigen und elektrisch anzuschließen.

10. Verfahren nach einem der vorstehenden Ansprüche, **dadurch gekennzeichnet, daß** es aufweist, mindestens ein passives Element (27) an der Trägerplatte zu befestigen und elektrisch anzuschließen.

11. Gehäuse für optische Halbleiterelemente, **dadurch gekennzeichnet, daß** es aufweist:
eine Trägerplatte (30) mit elektrischen Anschlüssen, welche interne und/oder externe Leitungen aufweist, die ein elektrisches Anschlußnetz (31) bilden, das Anschlußkontakte und/oder -zonen aufweist, und welche einen Durchgang (33) aufweist;
ein erstes Halbleiterelement (32), beispielsweise einen Mikroprozessor, dessen vordere Fläche an einer hinteren Fläche des Trägerplatte um den Durchgang (33) herum befestigt ist;
erste Einrichtungen zum elektrischen Anschließen des ersten Elements an der Trägerplatte;
ein zweites Halbleiterelement (32), dessen vordere Fläche einen optischen Sensor (21) aufweist und dessen hinteren Fläche direkt an der vorderen Fläche des ersten Elements (32) durch den Durchgang (32) der Trägerplatte (30) hindurch befestigt ist;
zweite Einrichtungen zum elektrischen Anschließen des zweiten Elements an der Trägerplatte;
einen Einkapselungsblock (42) des ersten Elements an der hinteren Fläche der Trägerplatte;
einen Einkapselungshohlraum (44), in dessen unterem Teil das zweite Element angeordnet ist und dessen vordere Wand (49) zumindest teilweise transparent ist; und
an einem unbedeckten Teil der Trägerplatte angeordnete externe Anschlußeinrichtungen.

12. Gehäuse nach Anspruch 11, **dadurch gekennzeichnet, daß** die Wand des Hohlraums (18) eine aus der vorderen Fläche der Trägerplatte vorspringende Einkapselungswand (17) und einen Deckel (25) aufweist, der an dem vorderen Ende der vorspringenden Wand befestigt ist und zumindest teilweise transparent ist.

13. Gehäuse nach Anspruch 11, **dadurch gekennzeichnet, daß** die Wand des Hohlraums (18) einen an der vorderen Fläche der Trägerplatte befestigten Deckel in Form einer Küvette aufweist.

14. Gehäuse nach einem der Ansprüche 11 bis 13, **dadurch gekennzeichnet, daß** es mindestens ein an der Trägerplatte (2) angeordnetes, passives Element (27) aufweist.

15. Gehäuse nach einem der Ansprüche 11 bis 14, **dadurch gekennzeichnet, daß** die ersten elektrischen Anschlußeinrichtungen elektrische Drähte (7) aufweisen.

16. Gehäuse nach einem der Ansprüche 11 bis 15, **dadurch gekennzeichnet, daß** die ersten elektrischen Anschlußeinrichtungen Metallkügelchen (37) aufweisen.

17. Gehäuse nach einem der Ansprüche 11 bis 16, **dadurch gekennzeichnet, daß** die zweiten elektrischen Anschlußeinrichtungen elektrische Drähte (22) aufweisen.

18. Gehäuse nach einem der Ansprüche 11 bis 17, **dadurch gekennzeichnet, daß** die Trägerplatte einen ausgesparten Teil (35) aufweist, an dessen Boden das erste Element (32) befestigt ist.

19. Gehäuse nach einem der Ansprüche 11 bis 18, **dadurch gekennzeichnet, daß** es mindestens ein passives Element (27) aufweist, das an der Trägerplatte befestigt ist und elektrisch mit dieser verbunden ist.
